(19) Europäisches Patentamt
European Patent Office
Office européen des brevets

(11) Numéro de publication: **0 112 245**
**B1**

(12)   **FASCICULE DE BREVET EUROPEEN**

(45) Date de publication du fascicule du brevet:
22.06.88

(51) Int. Cl.⁴: **F 42 B 3/12, H 01 C 17/28**

(21) Numéro de dépôt: 83402379.8

(22) Date de dépôt: 09.12.83

(54) Procédé pour la fabrication d'un circuit électrique destiné à la mise à feu d'un dispositif pyrotechnique et circuit ainsi obtenu.

(30) Priorité: 15.12.82 FR 8221024

(43) Date de publication de la demande:
27.06.84 Bulletin 84/26

(45) Mention de la délivrance du brevet:
22.06.88 Bulletin 88/25

(84) Etats contractants désignés:
AT BE CH DE GB IT LI NL SE

(56) Documents cités:
BE - A - 775 800
FR - A - 1 600 106
FR - A - 2 013 677

THIN SOLID FILMS, vol. 78, no. 2, avril 1981, Elsevier Sequoia, Lausanne (CH), R.K. NAHAR et al.: "Contact resistance characteristics of the low cost Cu/Ni-Cr thin film resistor system", p. 147-152

(73) Titulaire: SFERNICE SOCIETE FRANCAISE DE L'ELECTRO-RESISTANCE, 59, rue Gutenberg, F-75737 Paris Cedex 15 (FR)

(72) Inventeur: Flassayer, Claude, l'Orée des Pugets, Avenue Jean Aicard, F-06700 St. Laurent du Var (FR)
Inventeur: Le Grives, Bernard, 15 rue Andrioli, F-06000 Nice (FR)
Inventeur: Simon, Paul René, 15, rue Maréchal-Joffre, F-06000 Nice (FR)

(74) Mandataire: Bouju, André et al, Cabinet Bouju 38 avenue de la Grande Armée, F-75017 Paris (FR)

## Description

La présente invention concerne un procédé pour la fabrication d'un circuit électrique de faible dimension destiné à la mise à feu d'un dispositif pyrotechnique.

Les dispositifs de mise à feu électrique connus comprennent un circuit électrique qui comporte un élément électriquement résistant chauffant ou fusible sous l'effet du passage d'un courant électrique appliqué aux bornes du circuit afin de provoquer la déflagration de l'explosif qui est en contact avec cet élément résistant.

De tels dispositifs sont utilisés particulièrement pour la mise à feu des munitions utilisées dans les armes à tube telles que canons à tir rapide (3000 coups par minute ou plus).

Dans ces dispositifs de mise à feu, le circuit électrique est constitué par un circuit imprimé miniaturisé comprenant un fil électriquement résistant très fin de diamètre égal à une dizaine de microns qui est soudé sur ce circuit imprimé.

La soudure de ce fil électriquement résistant sur le circuit imprimé est une opération très délicate et par conséquent coûteuse.

De plus, les circuits ainsi réalisés sont relativement peu fiables. En effet, dans un tel circuit, la probabilité de mise à feu doit être nulle en dessous d'une tension électrique donnée appliquée au filament et doit être égale à l'unité dans un temps bien défini pour une tension supérieure à la valeur précitée. On conçoit que, s'il existe le moindre défaut de soudure du filament et si ce dernier présente des dimensions ou une section s'écartant tant soit peu des valeurs optimales, la mise à feu peut être obtenue dans certains cas à une tension nettement inférieure et dans d'autres cas à une tension supérieure à la valeur optimale souhaitée.

On connaît selon le brevet français 2 013 677 un procédé pour la fabrication d'un circuit électrique comprenant un élément électriquement résistant destiné à la mise à feu d'un dispositif pyrotechnique. Ce procédé comprend les étapes dans lesquelles on fixe une feuille en matériau électriquement résistant sur un support électriquement isolant, on grave sur cette feuille deux zones conductrices séparées par un élément électriquement résistant et on recouvre au moins en partie chacune de ces deux zones conductrices par une couche d'un matériau conducteur destiné à assurer le contact électrique avec des bornes d'amenée de courant électrique au circuit.

Ce document ne fournit aucune précision sur la façon d'obtenir un fonctionnement fiable du circuit obtenu.

Le but de la présente invention est de remédier aux inconvénients des circuits électriques connus en proposant un procédé de fabrication d'un circuit destiné à la mise à feu d'un dispositif pyrotechnique qui soit à la fois de mise en œuvre simple et économique et permettant d'obtenir un circuit dont le fonctionnement est beaucoup plus fiable que dans le cas des réalisations connues.

Suivant l'invention, ce procédé comprend les étapes suivantes:

on fixe une feuille en matériau électriquement résistant sur un support électriquement isolant,

on grave cette feuille de manière à obtenir deux zones séparées par un évidement et reliées entre elles par l'élément électriquement résistant,

on applique sur la feuille gravée une couche de nickel d'épaisseur de l'ordre de 100 nm puis une première couche de cuivre, d'épaisseur de l'ordre de 5 μm, après quoi,

on perce un trou à travers la feuille, le support, la couche de nickel et la première couche de cuivre,

afin de métalliser le trou, on dépose une deuxième couche de cuivre d'épaisseur inférieure ou égale à 5 μm, on dépose un masque de protection dans l'évidement, on dépose une troisième couche de cuivre d'épaisseur comprise entre 20 et 40 μm, ladite troisième couche étant destinée à assurer le contact électrique avec des bornes d'amenée de courant électrique au circuit, puis une couche d'étain-plomb d'épaisseur comprise entre 5 et 15 μm,

on enlève le masque de protection et on élimine par action chimique la deuxième couche de cuivre qui était protégée par le masque, et

on enlève par action chimique la couche extérieure d'étain-plomb.

Les couches de matériau conducteur appliquées sur les deux zones conductrices permettent d'obtenir un excellent contact électrique avec les bornes d'amenée de courant.

Les conditions de mise à feu du dispositif comportant un circuit ainsi réalisé sont de ce fait parfaitement reproductibles et fiables.

Selon un mode d'exécution avantageux du procédé, pour graver la feuille on recouvre cette dernière par un masque réalisé par photogravure et reproduisant le contour des zones conductrices et de l'élément à graver sur cette feuille et on soumet l'ensemble constitué par le masque et la feuille à l'action d'un agent d'érosion approprié pour éliminer la matière de la feuille en regard des zones de la feuille non recouvertes par le masque.

Des procédés de gravures d'une feuille électriquement résistante destinés notamment à la réalisation de résistances électriques ont été décrits dans les brevets français no 2 344 940 et no 2 354 617 de la demanderesse. Ces procédés permettent d'obtenir des gravures extrêmement fines et précises. Le filament électriquement résistant ainsi obtenu présente une valeur ohmique prédéterminée et parfaitement reproductible lors d'une fabrication en grande série.

D'autres particularités et avantages de l'invention apparaîtront encore dans la description ci-après.

Aux dessins annexés donnés à titre d'exemples non limitatifs:

— la figure 1 est une vue en coupe montrant la feuille résistive collée sur son support isolant et illustrant la première étape du procédé conforme à l'invention;

— la figure 2 est une vue en coupe montrant le masque appliqué sur la feuille et illustrant la deuxième étape du procédé;

— la figure 3 est une vue en coupe montrant la feuille résistive gravée et illustrant la troisième étape du procédé;

– la figure 4 est une vue illustrant la quatrième étape: application sur la feuille gravée d'une couche de nickel et d'une couche de cuivre;

– la figure 5 est une vue illustrant la cinquième étape: perçage d'un trou central à travers l'ensemble;

– la figure 6 est une vue montrant l'application d'une couche épaisse de cuivre;

– la figure 7 est une vue en coupe du circuit électrique terminée;

– la figure 8 est une vue de dessus de ce circuit;

– la figure 9 est une courbe montrant l'évolution de la probabilité de mise à feu en fonction de la tension appliquée aux bornes de cette dernière.

Pour fabriquer un circuit électrique confome à l'invention, on procède de préférence de la façon suivante:

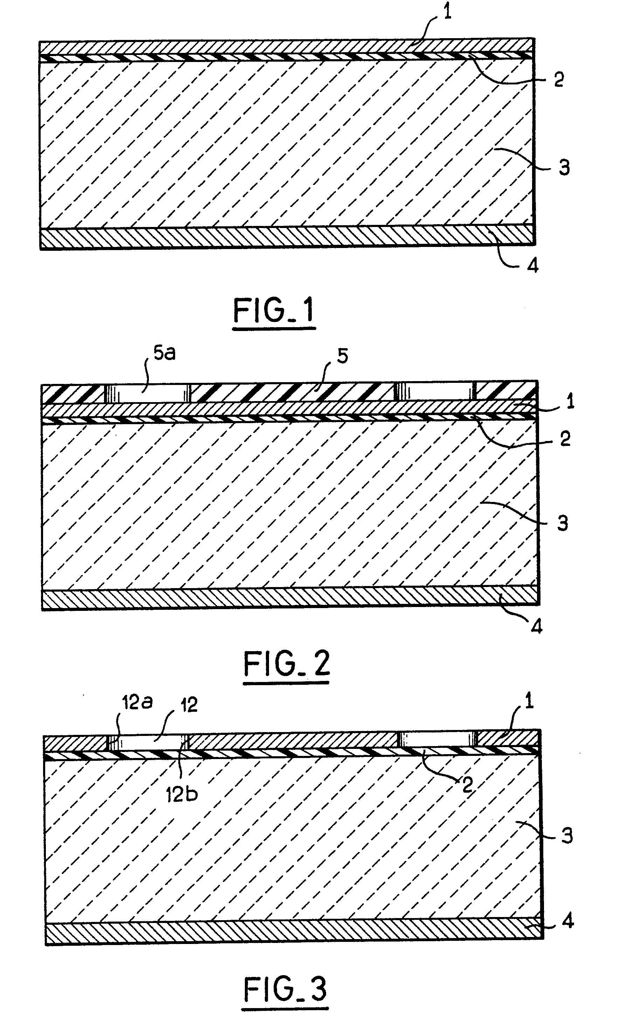

Dans une première étape (voir figure 1), on colle à l'aide d'une résine 2, une feuille 1 d'alliage de nickel et de chrome sur un support isolant 3 (par exemple en résine époxy, polyimide, polytétrafluoréthylène chargée de fibres de verre) d'épaisseur comprise entre 0,1 et 1 mm et plaqué sur sa face arrière d'une couche de cuivre 4 d'épaisseur comprise entre 10 et 70 microns.

Dans une deuxième étape (voir figure 2), on applique sur la feuille résistive 1 un masque 5 comportant des ouvertures 5a en regard des zones de la feuille 1 qui sont à graver. Ce masque 5 est obtenu en appliquant sur la feuille 1 une laque photosensible. Après séchage de celle-ci, on la soumet à l'action de la lumière au travers d'un cliché photographique reproduisant le circuit à graver. On procède ensuite à un développement et à une cuisson de la laque de masquage.

Dans une troisième étape, on soumet l'ensemble à un usinage chimique, électrochimique ou ionique, comme décrit par exemple dans les brevets français 2 344 940 et 2 354 617 de la demanderesse, pour graver les zones de la feuille résistive 1 situées en regard des ouvertures 5a du masque 5.

Après enlèvement du masque 5, la feuille 1 se présente sous la forme représentée sur la figure 3.

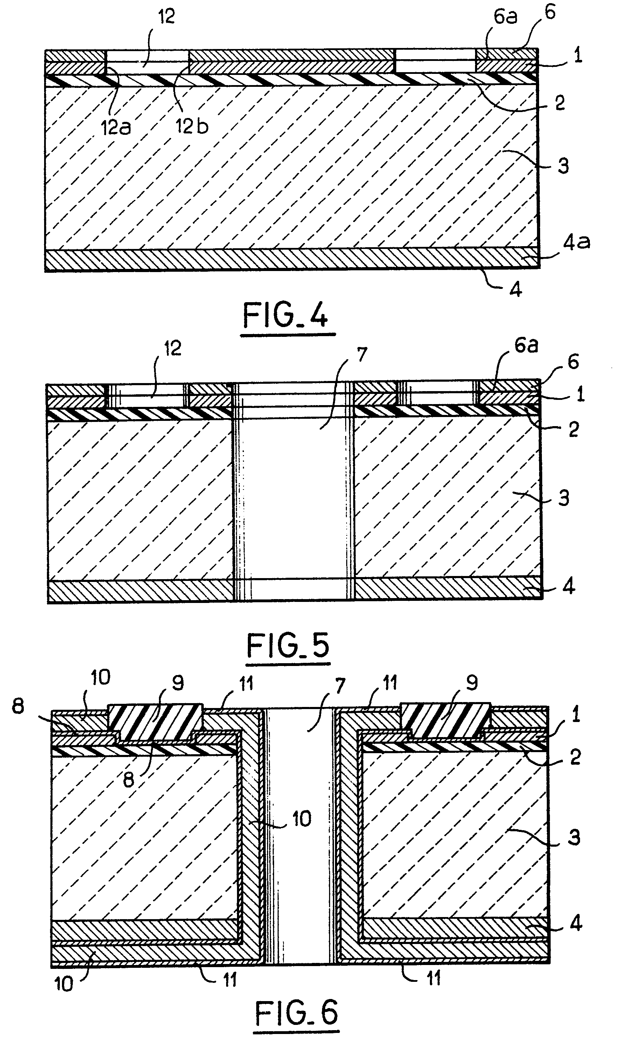

Dans une quatrième étape (voir figure 4), on applique sur la feuille résistive 1, après dégraissage de celle-ci, une fine couche 6a de nickel (épaisseur de l'ordre de 100 nm) puis une couche 6 de cuivre obtenue par dépôt électrolytique, d'épaisseur égale à 5 microns environ. Lors du dépôt des couches 6a et 6, la face arrière 4a est protégée par un film anti-acide.

Dans une cinquième étape (voir figure 5), on perce un trou 7 au centre à travers l'ensemble obtenu lors de la quatrième étape.

Dans une sixième étape on métallise le trou 7 après conditionnement préalable des parties à métalliser. Ce conditionnement élimine pratiquement en totalité la couche 6 de la figure 5.

A cet effet (voir figure 6):

– on dépose par voie chimique et électrolytique une fine couche de cuivre 8 (épaisseur ⩽ 5 microns) sur l'ensemble de la pièce;

– on dépose un masque de protection 9 dans les ouvertures gravées de la feuille résistive 1.

Ce masque 9 est obtenu comme décrit précédemment par insolation et développement;

– on dépose dans le trou 7 sur le deux faces de l'ensemble une couche de cuivre électrolytique 10 d'épaisseur comprise entre 20 et 40 microns, puis une couche d'étain-plomb électrolytique 11 d'épaisseur comprise entre 5 et 15 microns;

– on enlève le masque de protection 9;

– on élimine par gravure chimique la fine couche de cuivre 8 qui était protégée par le masque 9;

– on enlève la couche extérieure d'étain-plomb 11 par décapage chimique ou électrochimique.

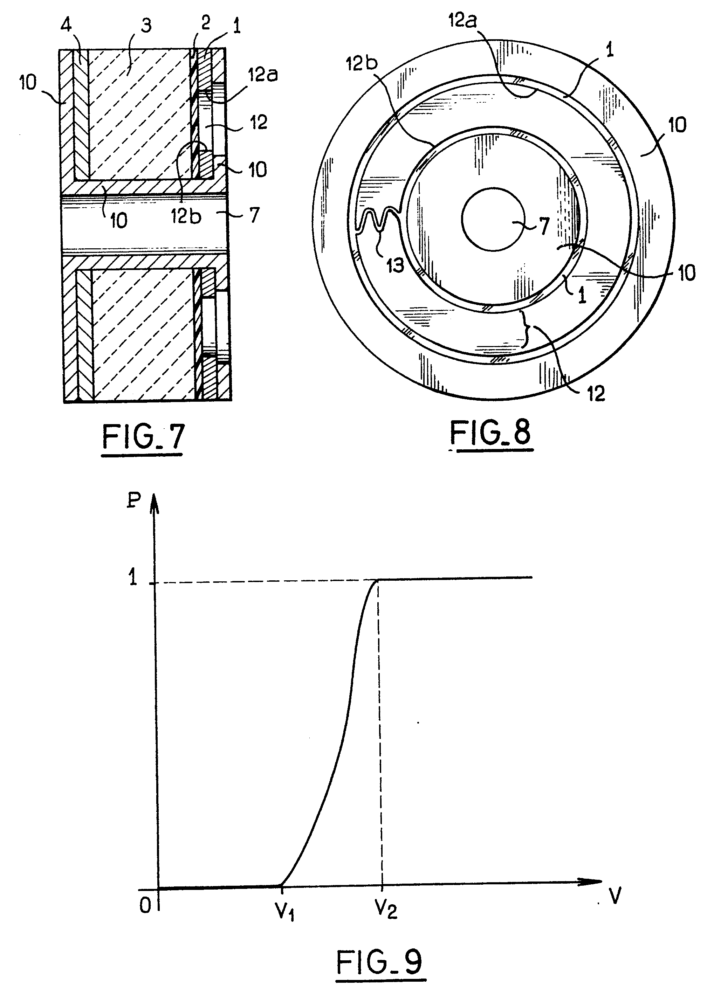

On obtient alors le circuit électrique représenté sur les figures 7 et 8.

On voit sur la figure 8, que le circuit électrique ainsi obtenu présente la forme d'un disque comprenant deux zones concentriques conductrices 12a, 12b gravées dans la feuille résistive 1, séparées par un évidement 12 en forme d'anneau fendu. Ces deux zones concentriques 12a, 12b sont reliées entre alles par un mince filament résistant 13 qui a été réalisé dans la feuille résistive lors de la troisième étape du procédé.

Ce filament résistant 13 présente avantageusement un profil sinueux pour augmenter sa longueur et la valeur ohmique de l'ensemble du circuit.

La forme en disque du circuit électrique selon l'invention peut être découpée à l'emporte-pièce dans une feuille reproduisant un grand nombre de circuits gravés, comme on vient de le décrire.

Dans tous les cas on obtient suivant le procédé selon l'invention, un filament résistant 13 présentant des dimensions parfaitement définies et reproductibles, avec de très faibles écartes de sa valeur ohmique lors d'une fabrication en très grande série.

Grâce à la parfaite reproductibilité des dimensions et de la valeur ohmique du filament résistant 13 du circuit, la probabilité P (voir figure 9) de mise à feu est quasi nulle en dessous d'une tension électrique inférieure à une valeur $V_2$ et cette probabilité de mise à feu est identique à l'unité et en un temps $\Delta t$ bien défini, pour une tension V supérieure à $V_2$.

La figure 9 illustre ainsi la parfaite fiabilité du fonctionnement du dispositif conforme à l'invention.

## Revendications

1. Procédé pour la fabrication d'un circuit électrique comprenant un élément électriquement résistant (13) destiné à la mise à feu d'un dispositif pyrotechnique, ledit procédé comprenant les étapes dans lesquelles:

on fixe une feuille (1) en matériau électriquement résistant sur un support électriquement isolant (3),

on grave cette feuille de manière à obtenir deux zones (12a, 12b) séparées par un évidement (12) et reliées entre elles par l'élément électriquement résistant (13),

on applique sur la feuille gravée (1) une couche de nickel (6a) d'épaisseur de l'ordre de 100 nm puis une première couche de cuivre (6), d'épaisseur de l'ordre de 5 μm, après quoi,

on perce un trou (7) à travers la feuille (1), le support (3), la couche de nickel (6a) et la première couche de cuivre (6),

afin de métalliser le trou (7), on dépose une deuxième couche de cuivre (8) d'épaisseur inférieure ou égale à 5 µm, on dépose un masque de protection (9) dans l'évidement (12), on dépose une troisième couche de cuivre (10) d'épaisseur comprise entre 20 et 40 µm, ladite troisième couche étant destinée à assurer le contact électrique avec des bornes d'amenée de courant électrique au circuit, puis une couche d'étain-plomb (11) d'épaisseur comprise entre 5 et 15 µm,

on enlève le masque de protection (9) et on élimine par action chimique la deuxième couche de cuivre (8) qui était protégée par le masque (9), et

on enlève par action chimique la couche extérieure (11) d'étain-plomb.

2. Procédé conforme à la revendication 1, caractérisé en ce que pour graver la feuille (1) on recouvre cette dernière par un masque (5) réalisé par photogravure et reproduisant le contour des zones conductrices (12a, 12b) et de l'élément (13) à graver sur cette feuille et on soumet l'ensemble constitué par le masque (5) et la feuille (1) à l'action d'un agent d'érosion approprié pour éliminer la matière de la feuille en regard des zones de la feuille non recouvertes par le masque (5).

## Patentansprüche

1. Verfahren zur Herstellung einer elektrischen Schaltung, die ein elektrisches Widerstandselement (13) enthält, das zum Zünden einer pyrotechnischen Vorrichtung bestimmt ist, wobei das Verfahren die Schritte enthält, in denen

– eine Folie (1) aus elektrischem Widerstandsmaterial auf einem elektrisch isolierenden Träger (3) befestigt wird,

– diese Folie so graviert wird, daß zwei durch eine Aussparung (12) getrennte Zonen (12a, 12b) erhalten werden, die durch das elektrische Widerstandselement (13) miteinander verbunden sind,

– auf der gravierten Folie (1) eine Nickelschicht (6a) einer Dicke in der Größenordnung von 100 µm und anschließend eine erste Kupferschicht (6) aufgebracht wird, woraufhin

– ein Loch (7) durch die Folie (1), den Träger (3), die Nickelschicht (6a) und die erste Kupferschicht (6) gebohrt wird,

– zum Metallisieren des Loches (7) eine zweite Kupferschicht (8) einer Dicke von höchstens 5 µm aufgebracht wird, eine Schutzmaske (9) in die Ausnehmung (12) gelegt wird, eine dritte Kupferschicht (10) einer Dicke zwischen 20 und 40 µm aufgebracht wird, welche dritte Schicht dazu bestimmt ist, den elektrischen Kontakt mit den Anschlüssen für die Zufuhr elektrischen Stromes zur Schaltung herzustellen, und danach eine Schicht (11) aus Zinn und Blei aufgebracht wird, deren Dicke zwischen 5 und 15 µm beträgt,

– die Schutzmaske (9) entfernt und durch chemische Einwirkung die zweite Kupferschicht (8) beseitigt wird, welche durch die Maske (9) geschützt wurde, und

– durch chemische Einwirkung die äußere Schicht (11) aus Zinn und Blei entfernt wird.

2. Verfahren nach Anspruch 1, dadurch gekennzeichnet, daß zum Gravieren der Folie (1) diese mit einer Maske (5) abgedeckt wird, die durch Photogravur hergestellt ist und die Kontur der leitenden Zonen (12a, 12b) sowie des auf dieser Folie zu gravierenden Elements (13) wiedergibt, und die aus der Maske (5) und der Folie (1) gebildete Einheit der Wirkung eines geeigneten Erosionsmittels ausgesetzt wird, um das Folienmaterial gegenüber denjenigen Zonen der Folie, die von der Maske (5) nicht abgedeckt sind, zu entfernen.

## Claims

1. A method of manufacturing an electrical circuit comprising an electrically resistant element (13) adapted to fire a pyrotechnic device, said method comprising the steps in which:

a sheet (1) of electrically resistant material is fixed on an electrically insulating support (3),

said sheet is engraved to form two zones (12a, 12b) separated by a recess (12) and interconnected by the electrically resistant element (13),

a layer of nickel (6a) of a thickness of the order of 100 µm is applied to the engraved sheet (1) and then a first layer of copper (6) of a thickness of about 5 µm, whereupon

a hole (7) is pierced through the sheet (1), the support (3), the layer of nickel (6a) and the first layer of copper (6),

in order to metallise the hole (7) a second layer of copper (8) of a thickness less than or equal to 5 µm is deposited, a protective mask (9) is deposited in the recess (12), a third layer of copper (10) of a thickness of between 20 and 40 µm is deposited, said third layer being adapted to provide electrical contact with the terminals for the supply of electrical current to the circuit, and then a layer of tin-lead (11) of a thickness between 5 and 15 µm is deposited,

the protective mask (9) is removed and the second layer of copper (8) which was protected by the mask (9) is eliminated by chemical action, and

the outer layer (11) of tin-lead is removed by chemical action.

2. A method according to claim 1, characterised in that for the purpose of engraving the sheet (1) the sheet is covered by a mask (5) formed by photogravure and reproducing the contour of the conductive zones (12a, 12b) and of the element (13) to be engraved on said sheet and the system comprising the mask (5) and the sheet (1) is subjected to the action of an appropriate erosion agent to eliminate the sheet material opposite those zones of the sheet which are not covered by the mask (5).

## FIG_1

## FIG_2

## FIG_3

FIG. 4

FIG. 5

FIG. 6

FIG. 7

FIG. 8

FIG. 9

9